# EUROPEAN PATENT APPLICATION

(11) **EP 1 104 099 A1**
(43) Date of publication of application: **30.05.2001**
(21) Application number: 00935588.4
(22) Date of filing: 08.06.2000
(51) Int. Cl.: H03H 9/19

(54) **PIEZOELECTRIC VIBRATOR**

(30) Priority: 08.06.1999 JP 19640499
(71) Applicant: ALSTOM Power N.V., 1101 CS Amsterdam (NL)
(72) Inventor: ALSTOM Power N.V., 1101 CS Amsterdam (NL)
(74) Representative: Pöpper, Evamaria, Dr.
(86) International application number: JP0003715
(87) International publication number: WO0076066

(57) **Abstract**

The piezoelectric resonator is provided with a piezoelectric substrate (100) of a quartz plate, electrodes (101, 102) mounted on the front and rear sides of the piezoelectric substrate (100), quartz protective substrates (105, 106) disposed to be superposed on the front and rear sides of the piezoelectric substrate (100), having the same material and the same cut angle as the piezoelectric substrate (100), and junctions (107, 108, 109, 110) containing gold and silver, which connect the piezoelectric substrate (100) and the protective substrates (105, 106) by means of the diffused junction or the cold junction. With this construction, the piezoelectric substrate (100) is sealed by the junctions (107 - 110). The junctions (107 - 110) are formed by means of the diffused junction or the cold junction, so that the electric resistance thereof is maintained low.

## Description

### Technical Field

The present invention relates to a technique of manufacturing a piezoelectric resonator, in which the piezoelectric resonator and the package thereof are apparently integrated into a unit, so that the package is needless to handle.

### Background Technology

Accompanied with the recent trend for a larger capacity and a higher frequency in the mobile telephone field, various types of filters including a piezoelectric resonator being an electromechanical functional component using a piezoelectric material and a SAW (Surface Acoustic Wave) filter have been required to fit in with the trend for a still further miniaturization and thinness, and for a higher frequency. In most cases, the piezoelectric resonator or the piezoelectric filter utilizing the bulk wave is used for the range 10 MHz ∼ 100 MHz, and the SAW filter utilizing the Surface Acoustic wave is used for the range 100 MHz ∼ 1 GHz.

The crystal as a piezoelectric material has the most excellent characteristics of the piezoelectric materials in that it has a very high Q-factor and a high frequency stability against temperature; and various piezoelectric products using the crystal are materialized as a crystal resonator or a monolithic crystal filter.

Now, in these piezoelectric products, thin film electrodes are formed on both the front and rear sides of a piezoelectric plate such as a crystal. And, a RF voltage is applied to the piezoelectric resonator to resonate it utilizing the piezoelectric effect. Accordingly, the piezoelectric resonator is housed in a ceramic package and the like. In this case, the thin film electrodes are to be protected from a bad influence by an external environmental change. The ceramic package is provided with a seal ring for a hermetic sealing, and after the crystal resonator is mounted inside the ceramic package, a metal cap is covered on the seal ring, which is hermetically sealed by means of the seam welding, thus maintaining a high reliability. A conductive adhesive connects formed leader electrodes with electrode terminals formed inside the ceramic package that apply a RF voltage to the leader electrodes. The conductive adhesive has conductivity, whereby the supply RF voltage terminal is electrically connected to the leader electrodes.

However, the resistance of a silver filler contained in the conductive adhesive can increase due to the aging characteristic and the like. Accordingly, the effective RF voltage will decrease which is applied to the piezoelectric resonator from the power supply of a constant RF voltage. Thus, the drive RF voltage applied to the piezoelectric resonator is lowered, and thereby an accurate resonant vibration cannot be maintained.

Accordingly, it is a major object of the invention to provide a crystal resonator that does not require a conventional ceramic package, and a piezoelectric resonator that realizes a crystal resonator of a high Q-factor with a vacuum sealing, and that possesses a high stability and reliability with an extremely low aging characteristic of the thin film electrodes as sealed in a vacuum.

### Disclosure of the Invention

The present invention described in claim 1 is a piezoelectric resonator, which includes a piezoelectric substrate that generates a piezoelectric resonator; electrodes mounted on a front side and a rear side of the piezoelectric substrate; protective substrates of the same material as the piezoelectric substrate, disposed to be superposed on the front side and the rear side of the piezoelectric substrate; and junctions that connect the piezoelectric substrate and the protective substrates by means of a diffused junction or a cold junction.

The piezoelectric resonator constructed as above forms the junctions under a relatively low temperature lower than 300°C by the diffused junction method or by the cold junction method; and therefore, there does not exist any thermal influence at the junction interfaces, and the piezoelectric resonator according to the invention is capable of forming very good interfaces both in strength and quality.

Moreover, since the materials of the piezoelectric substrate and the protective substrates are the same, the hermetic sealing of the piezoelectric substrate will not be broken by a thermal expansion.

The present invention described in claim 2 is a piezoelectric resonator as claimed in claim 1, wherein the junctions are made of either one of more than one type of metals, diamonds, boron, and carbon nitride.

Metals here are, for example, platinum, gold, silver, copper, aluminum, nickel, chromium, molybdenum, tungsten, titanium, palladium, niobium, tantalum, beryllium, magnesium, tin, indium, and lead. The junctions are formed either by one of these metals or by combining more than two kinds of them.

The boron is especially preferably the cubic boron (cBN). The carbon nitride is especially preferably the hexagonal carbon nitride (βC₃N₄).

The present invention described in claim 3 is a piezoelectric resonator as claimed in claim 1, wherein the piezoelectric substrate is made of either one of a single crystal piezoelectric substrate, piezoelectric ceramics, and a piezoelectric polymer.

The single crystal piezoelectric substrate signifies, for example, crystal, lithium tantalate, lithium niobate, lithium tetraborate, langasite, and aluminum phosphate. One of these single crystal piezoelectric substrates is served as the piezoelectric substrate.

The present invention described in claim 4 is a piezoelectric resonator as claimed in claim 1, which further includes: external connection electrodes provided with the protective substrates; and external leader electrodes made of a metal, which connect the junctions and the external connection electrodes by means of the diffused junction or the cold junction.

The metals here are the ones with a relatively high conductivity. For example, platinum, gold, silver, copper, and aluminum. One of these is chosen as the material for the external leader electrode.

The present invention described in claim 5 is a piezoelectric resonator as claimed in claim 1, which further includes internal leader electrodes made of a metal, which connect the electrodes and the junctions by means of the diffused junction or the cold junction.

The metals here are the ones with a relatively high conductivity. For example, platinum, gold, silver, copper, and aluminum. One of these is chosen as the material for the internal leader electrode.

The present invention described in claim 6 is a piezoelectric resonator as claimed in claim 1, wherein a thickness of the junctions is greater than a thickness of the electrodes.

The present invention described in claim 7 is a piezoelectric resonator as claimed in claim 1, wherein the piezoelectric substrate has recessed parts where the electrodes are mounted.

The present invention described in claim 8 is a piezoelectric resonator as claimed in claim 1, wherein the protective substrates have recessed parts in correspondence with the electrodes.

The present invention described in claim 9 is a piezoelectric resonator as claimed in claim 1, wherein the piezoelectric substrate and the protective substrates are made of single crystal plates of the same cut angle.

The present invention described in claim 10 is a piezoelectric resonator as claimed in claim 1, wherein the piezoelectric substrate is made of a crystal, and the junctions contain gold and silver.

### Brief Description of the Drawings

Figure 1 is a sectional view of the piezoelectric resonator relating to the first embodiment of the invention;
Figure 2 is a sectional view of the piezoelectric resonator relating to the second embodiment of the invention; and
Figure 3 is a sectional view of the piezoelectric resonator relating to the third embodiment of the invention.

### Best Mode for Carrying out the Invention

The Embodiments of the invention will hereafter be described with reference to the accompanying drawings.

### First Embodiment

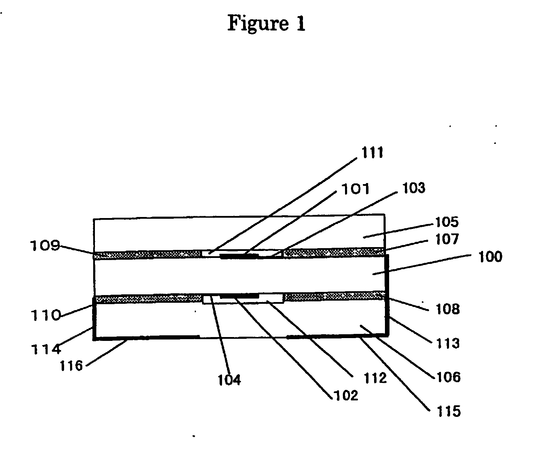

Figure 1 is a sectional view of the piezoelectric resonator relating to the first embodiment of the invention. The piezoelectric resonator relating to the first embodiment is provided with a piezoelectric substrate 100, electrodes 101, 102, protective substrates 105, 106, and junctions 107, 108, 109, 110.

The material of the piezoelectric substrate 100 may be one of a single crystal, piezoelectric ceramics, or a piezoelectric polymer. The single crystal piezoelectric substrate represents, for example, crystal, lithium tantalate, lithium niobate, lithium tetraborate, langasite, and aluminum phosphate.

In this embodiment, the piezoelectric substrate 100 is stipulated as a mirror polished quartz plate (AT-cut: 3° 00′) with a diameter ⌀ 5mm and a thickness of 80 µm. In this case, the fundamental frequency of the thickness vibration is 20MHz.

The electrodes 101, 102 are thin films of Ag 2000 Å formed by the vapor deposition method, which overlie NiCr 200 Å as a substrate. The electrode diameter is ⌀ 1.0 mm. The electrodes 101, 102 are placed on both the front and rear sides of the piezoelectric substrate 100.

The protective substrates 105, 106 are made with the same material as the piezoelectric substrate 100. This embodiment employs a quartz. Also in this embodiment, the protective substrates 105, 106 take on the same form as the piezoelectric substrate 100, and the same cut angle as well. They are also specularly polished. The protective substrate 105 is placed on the front side of the piezoelectric substrate 100, and the protective substrate 106 is placed on the rear side of the piezoelectric substrate 100.

The junctions 107, 108, 109, 110 contain gold and silver. The junctions 107, 108, 109, 110 connect the piezoelectric substrate 100 and the protective substrates 105, 106 by the cold junction method or the diffused junction. Also, the thickness of the junctions 107, 108, 109, 110 is thicker than the thickness of the electrodes 101, 102. This secures the spaces 111, 112 for the oscillation area of the piezoelectric substrate 100.

In this embodiment, on both the front and rear sides of the piezoelectric substrate 100, air-gaps of ⌀ 2mm are made at the center thereof, and thin films of Au 5000 Å are concentrically formed by the vapor deposition method, which overlie NiCr 200 Å as a substrate. And, on the surfaces of the protective substrates 105, 106, which face the piezoelectric substrate 100, the air-gaps of ⌀ 2mm are made at the center thereof, and thin films of Ag 5 µm are concentrically formed by the vapor deposition method, which overlie NiCr 200 Å as a substrate.

Now, these thin films may be formed by the sputtering method or the ion plating as well as the vapor deposition method. The thickness of the thin films formed by these thin films forming techniques are from several thousand Å to some tens µm.

After the plasma process of the junction surfaces, the piezoelectric substrate 100 and the protective substrates 105, 106 are superposed, which is sandwiched between the two metal jigs for junction so as to exert the force of 80Kg · f to 100Kg · f evenly to the entire quartz plate. Then it is heated in the vacuum furnace under 310°C for one hour. The reason that the vacuum furnace is used is because unless the adsorbed layers (moisture, oxygen, and oxide film) are removed, the perfect junction cannot be realized. This is the same as in the following embodiments. The junction in the vacuum results in the high Q-factor that represents the capability of avoiding a dissipation of vibration energy into the air, and leads to an advantage of lowering the equivalent resistance of a possible resonating element. The sealing in the vacuum effects an excellent result in the aging characteristics, and secures the stability of the electrode thin films on the piezoelectric plate.

Thus, the junctions 107, 108, 109, 110 connect the piezoelectric substrate 100 and the protective substrates 105, 106 by the cold junction method or diffused junction. Actually, after a test sample is taken out of the vacuum furnace and is exposed in the natural condition, a physical destructive inspection is executed to the junction surface thereof, which confirmed a satisfactory diffused junction.

In comparison to this type of diffused junction method, the conventional brazed and soldered junction method that inserts the insulator (foil of indium, etc.) between the metal foils sometimes can create a phenomenon that the outflows of melted metal junction metal foils from both ends are different, or that the metal foils are connected unevenly, depending on the condition at the time of the junction being made, and also the experiment confirmed that the metal foils are connected to be tapered.

However, in case of the combination of a gold thin film and a silver thin film, although the plasma treatment is not executed to the junction surfaces, if the pressure is applied evenly to the piezoelectric substrate 100 and the protective substrates 105, 106 that are to be connected, it is confirmed that they can be connected only by the diffused junction processing, and there is not a problem in the connection layers.

Also, in this embodiment, the junctions 107, 108, 109, 110 are defined to contain gold and silver. But, they may be made of more than one type of metals, diamonds, boron, or carbon nitride.

The metals mentioned above are, for example, platinum, gold, silver, copper, aluminum, nickel, chromium, molybdenum, tungsten, titanium, palladium, niobium, tantalum, beryllium, magnesium, tin, indium, and lead. The junction is formed either by one of these types of metals or by combining more than two types of them.

The boron is especially preferably the cubic boron (cBN). The carbon nitride is especially preferably the hexagonal carbon nitride (βC₃N₄).

An internal leader electrode 103 connects the electrode 101 and the junction 107 by either cold junction processing or the diffused junction. An internal leader electrode 104 connects the electrode 102 and the junction 110 by either cold junction processing or the diffused junction. The metal mentioned above is a metal with a relatively high conductivity, which is, for example, platinum, gold, silver, copper, and aluminum. One of these metals is used as the material for the internal leader electrode.

External connection electrodes 115, 116 are to connect the electrodes 101 and 102 to the power supply, which is omitted in the drawing. The external connection electrodes 115, 116 are placed on one side of the protective substrate 106, on the opposite side thereof that faces the piezoelectric substrate 100. The gold electrode processing is applied to the surfaces of the external connection electrodes 115, 116.

The external connection electrode 115 is electrically connected to the electrode 101 by way of the junction 107 and an external leader electrode 113. The external leader electrode 113 is placed on the sides of the piezoelectric substrate 100 and the protective substrate 106, and connects the junction 107 and the external connection electrode 115 by means of the cold junction processing or the diffused junction. The material used for the external leader electrode 113 is a metal with a relatively high conductivity. For example, platinum, gold, silver, copper, and aluminum. One of these metals is used as the material for the external leader electrode. Also, the gold electrode processing is applied to the surface of the external leader electrode 113.

The external connection electrode 116 is electrically connected to the electrode 102 by way of the junction 110 and an external leader electrode 114. The external leader electrode 114 is placed on the side of the protective substrate 106, and connects the junction 110 and the external connection electrode 116 by means of the cold junction processing or the diffused junction. The material used for the external leader electrode 116 is a metal with a relatively high conductivity. For example, platinum, gold, silver, copper, and aluminum. One of these metals is used as the material for the external leader electrode. Also, the gold electrode processing is applied to the surface of the external leader electrode 114.

By this construction, the piezoelectric resonator acquires the central frequency of 20.5MHz, and the equivalent resistance lower than 10 Ω. Also, there is no need to mention that the same effect can be acquired, even if the formation of the hermetic sealing part and that of the electrical connection part each are made independently.

According to the first embodiment, the piezoelectric substrate 100 can be sealed by the junctions 107, 108, 109, 110. The junctions 107, 108, 109, 110 form very good connection planes both in strength and quality without any thermal influence on the connection interfaces, because the diffused junction processing under a relatively low temperature lower than 300°C or the cold junction processing is applied to these junctions.

Further, the external leader electrodes 113, 114, and the internal leader electrodes 103, 104 are the metals with a relatively high conductivity. Since the external connection electrodes and the electrodes are connected by the diffused junction processing under a relatively low temperature lower than 300°C or the cold junction processing, very good connection planes can be formed both in strength and quality without any thermal influence on the connection interfaces.

Furthermore, since the materials used for the piezoelectric substrate 100 and the protective substrates 105, 106 are the same, the hermetic sealing of the piezoelectric substrate 100 will not be broken by a thermal expansion.

Also, since the thickness of the junctions 107, 108, 109, 110 is larger than the thickness of the electrodes 101, 102, the oscillation area for the piezoelectric substrate 100 can be secured.

### Second Embodiment

The piezoelectric resonator relating to the second embodiment differs in contrast to the piezoelectric resonator relating to the first embodiment, in that recessed parts 211, 212 are formed by applying the mesa processing or the like to protective substrates 205, 206.

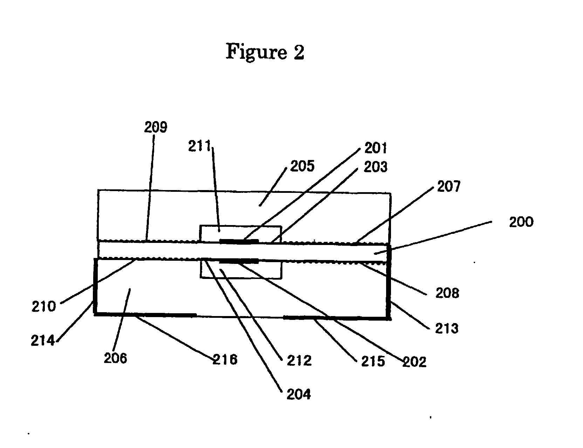

Figure 2 is a sectional view of the piezoelectric resonator relating to the second embodiment of the invention. The piezoelectric resonator relating to the second embodiment is provided with a piezoelectric substrate 200, electrodes 201, 202, the protective substrates 205, 206, and junctions 207, 208, 209, 210.

The material of the piezoelectric substrate 200 may be one of a single crystal, piezoelectric ceramics, or a piezoelectric polymer. The single crystal piezoelectric substrate represents, for example, crystal, lithium tantalate, lithium niobate, lithium tetraborate, langasite, and aluminum phosphate.

In this embodiment, the piezoelectric substrate 200 is stipulated as a mirror polished quartz plate (AT-cut: 3° 00′) with a diameter ⌀ 5mm and a thickness of 80 µm. In this case, the fundamental frequency of the thickness vibration is 20MHz.

The electrodes 201, 202 are thin films of Ag 2000 Å formed by the vapor deposition method, which overlie NiCr 200 Å as a substrate. The diameter is 1.0 mm. The electrodes 201, 202 are placed on both the front and rear sides of the piezoelectric substrate 200.

The protective substrates 205, 206 are made with the same material as the piezoelectric substrate 200. This embodiment employs a quartz. Also in this embodiment, the protective substrate 205, 206 take on the same cut angle as the piezoelectric substrate 200. They also have the mirror polishing applied. However, since the recessed parts 211, 212 are formed, the thickness of the protective substrate 205, 206 is 240 µm, which is thicker than that of the same in the first embodiment. The protective substrate 205 is placed on the front side of the piezoelectric substrate 200, and the protective substrate 206 is placed on the rear side of the piezoelectric substrate 200.

The junctions 207, 208, 209, 210 contain gold and silver. The junctions 207, 208, 209, 210 connect the piezoelectric substrate 200 and the protective substrates 205, 206 by the cold junction method or the diffused junction.

In this embodiment, on both the front and rear sides of the piezoelectric substrate 200, air-gaps of ⌀ 2mm are made at the center thereof, and thin films of Au 5000 Å are concentrically formed by the vapor deposition method, which overlie NiCr 200 Å as a substrate. And, on the surfaces of the protective substrates 205, 206, which face the piezoelectric substrate 200, the air-gaps of ⌀ 2mm are made at the center thereof, and thin films of Ag 5 µm are concentrically formed by the vapor deposition method, which overlie NiCr 200 Å as a substrate.

After the plasma treatment of the junction surfaces, the piezoelectric substrate 200 and the protective substrates 205, 206 are superposed, which is sandwiched between the two metal jigs for junction so as to exert the force of 80Kg · f to 100Kg · f evenly to the entire quartz plate. Then it is heated in the vacuum furnace under 310°C for one hour. Thus, the junctions 207, 208, 209, 210 connect the piezoelectric substrate 200 and the protective substrates 205, 206 by the cold junction method or diffused junction. Actually, after a test sample is taken out of the vacuum furnace and is exposed in the natural condition, a physical destructive inspection is executed to the junction surface thereof, which confirmed a satisfactory diffused junction.

However, in case of the combination of a gold thin film and a silver thin film, although the plasma treatment is not executed to the junction surfaces, if the pressure is applied evenly to the piezoelectric substrate 200 and the protective substrates 205, 206 that are to be connected, it is confirmed that they can be connected only by the diffused junction processing, and there is not a problem in the connection layers.

Also in this embodiment, the junctions 207, 208, 209, 210 are defined to contain gold and silver. But, they may be made of more than one type of metals, diamonds, boron, or carbon nitride.

The metals mentioned above are, for example, platinum, gold, silver, copper, aluminum, nickel, chromium, molybdenum, tungsten, titanium, palladium, niobium, tantalum, beryllium, magnesium, tin, indium, and lead. The junction is formed either by one of these types of metals or by combining more than two types of them.

The boron is especially preferably the cubic boron (cBN). The carbon nitride is especially preferably the hexagonal carbon nitride (βC₃N₄).

An internal leader electrode 203 connects the electrode 201 and the junction 207 by either cold junction processing or the diffused junction. An internal leader electrode 204 connects the electrode 202 and the junction 210 by either cold junction processing or the diffused junction. The metal mentioned above is a metal with a relatively high conductivity, which is, for example, platinum, gold, silver, copper, and aluminum. One of these metals is used as the material for the internal leader electrode.

The recessed parts 211, 212 for securing the oscillation area are formed by applying the chemical etching to the mirror polished protective substrates 205, 206 having the same azimuth as the piezoelectric substrate 200, a diameter ⌀ 5mm, and a thickness of 240 µm, in the solution ammonium hydrogen fluoride that is heated to 90°C. The dimension thereof is ⌀ 2mm, located at the center of the protective substrates 205, 206, and the depth is 20 µm from the surfaces of the protective substrates 205, 206.

Also, as the method of forming the recessed parts 211, 212 of the protective substrates 205, 206, in addition to the chemical etching, the ultrasonic machining or the high speed cutting by the diamond bite as a machining is possible. In the case of the machining, the machining part can be processed to the depth of 50 µm while cooling the part with the grinding fluid. Besides, concerning the junction, the same result as the recessed parts formed by the chemical etching is confirmed.

External connection electrodes 215, 216 are to connect the electrodes 201 and 202 to the RF power supply, which is omitted in the drawing. The external connection electrodes 215, 216 are placed on one side of the protective substrate 206, on the opposite side thereof that faces the piezoelectric substrate 200. The gold electrode treatment is applied to the surfaces of the external connection electrodes 215, 216.

The external connection electrode 215 is electrically connected to the electrode 201 by way of the junction 207 and an external leader electrode 213. The external leader electrode 213 is placed on the sides of the piezoelectric substrate 200 and the protective substrate 206, and connects the junction 207 and the external connection electrode 215 by means of the cold junction processing or the diffused junction. The material used for the external leader electrode 213 is a metal with a relatively high conductivity. For example, platinum, gold, silver, copper, and aluminum. One of these metals is used as the material for the external leader electrode. Also, the gold electrode processing is applied to the surface of the external leader electrode 213.

The external connection electrode 216 is electrically connected to the electrode 202 by way of the junction 210 and an external leader electrode 214. The external leader electrode 214 is placed on the side of the protective substrate 206, and connects the junction 210 and the external connection electrode 216 by means of the cold junction processing or the diffused junction. The material used for the external leader electrode 216 is a metal with a relatively high conductivity. For example, platinum, gold, silver, copper, and aluminum. One of these metals is used as the material for the external leader electrode. Also, the gold electrode processing is applied to the surface of the external leader electrode 214.

By this construction, the piezoelectric resonator acquires the central frequency of 20.5MHz, and the equivalent resistance lower than 10 Ω. Also, there is no need to mention that the same effect can be acquired, even if the formation of the hermetic sealing part and that of the electrical connection part each are made independently.

According to the second embodiment, the piezoelectric substrate 200 can be sealed by the junctions 207, 208, 209, 210. Since the junctions 207, 208, 209, 210 are formed by means of the diffused junction or the cold junction, the electrical resistance thereof can be maintained low. Also, the junction parts have a greater strength than a fusible glass, so that they can be made extremely thin, and the piezoelectric substrate 200 and the protective substrates 205, 206 can be treated as if they were integrated into one unit. This means exactly the "package less".

Further, the external leader electrodes 213, 214, and the internal leader electrodes 203, 204 use the metals with a relatively high conductivity. Since the external connection electrodes and the electrodes are connected by the diffused junction processing under a relatively low temperature lower than 300°C or the cold junction processing, very good connection planes can be formed both in strength and quality without any thermal influence on the connection interfaces.

Furthermore, since the materials used for the piezoelectric substrate 200 and the protective substrates 205, 206 are the same, the hermetic sealing of the piezoelectric substrate 200 will not be broken by a thermal expansion.

Also, the recessed parts 211, 212 secure the oscillation area for the piezoelectric substrate 200.

### Third Embodiment

The piezoelectric resonator relating to the third embodiment differs in contrast to the piezoelectric resonator relating to the first embodiment, in that recessed parts 312, 313 are formed by applying the mesa processing or the like to a piezoelectric substrate 300.

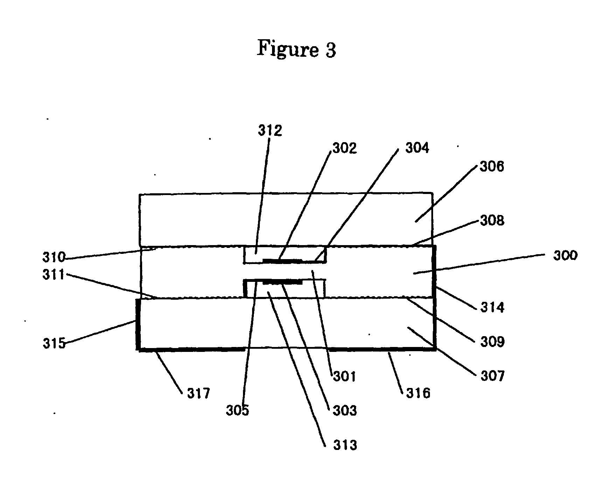

Figure 3 is a sectional view of the piezoelectric resonator relating to the third embodiment of the invention. The piezoelectric resonator relating to the third embodiment is provided with the piezoelectric substrate 300, electrodes 302, 303, protective substrates 306, 307, and junctions 308, 309, 310, 311.

The material of the piezoelectric substrate 300 may be one of a single crystal, piezoelectric ceramics, or a piezoelectric polymer. The single crystal piezoelectric substrate represents, for example, crystal, lithium tantalate, lithium niobate, lithium tetraborate, langasite, and aluminum phosphate.

In this embodiment, the piezoelectric substrate 300 is stipulated as a mirror polished quartz plate (AT-cut: 3° 00′) with a diameter ⌀ 5mm and a thickness of 120 µm. In this case, the fundamental frequency of the thickness vibration is 20MHz. The thickness of the piezoelectric substrate 300 is greater than the thickness of the same in the first and the second embodiments, because the recessed parts 312, 313 are formed on the piezoelectric substrate 300.

The recessed parts 312, 313 are formed by applying the chemical etching in a heated solution ammonium hydrogen fluoride to the center with a diameter ⌀ 2mm from both directions, up to a depth of 40 µm from the surfaces each. The thickness of a mesa-processed part 301 is 40 µm.

Also, as the method of forming the recessed parts 312, 313 of the piezoelectric substrate 300, in addition to the chemical etching, the ultrasonic machining or the high speed cutting by the diamond bite as a machining is possible. In the case of the machining, the machining part can be processed to the depth of 50 µm while cooling the part with the grinding fluid. Besides, concerning the junction, the same result as the recessed parts formed by the chemical etching is confirmed.

The electrodes 302, 303 are thin films of Ag 1000 Å formed by the vapor deposition method, which overlie NiCr 100 Å as a substrate. The diameter is 1.0 mm. The electrodes 302, 303 are placed on both the front and rear sides of the piezoelectric substrate 300.

The protective substrates 306, 307 are made with the same material as the piezoelectric substrate 300. This embodiment employs a quartz. Also in this embodiment, the protective substrate 306, 307 take on the same cut direction and the same form as the piezoelectric substrate 300. They also have the mirror polishing applied. The protective substrate 306 is placed on the front side of the piezoelectric substrate 300, and the protective substrate 307 is placed on the rear side of the piezoelectric substrate 300.

The junctions 308, 309, 310, 311 contain gold and silver. The junctions 308, 309, 310, 311 connect the piezoelectric substrate 300 and the protective substrates 306, 307 by the cold junction method or the diffused junction.

In this embodiment, on both the front and rear sides of the piezoelectric substrate 300, air-gaps of ⌀ 2mm are made at the center thereof, and thin films of Au 5000 Å are concentrically formed by the vapor deposition method, which overlie NiCr 200 Å as a substrate. And, on the surfaces of the protective substrates 306, 307, which face the piezoelectric substrate 300, the air-gaps of ⌀ 2mm are made at the center thereof, and thin films of Ag 5 µm are concentrically formed by the vapor deposition method, which overlie NiCr 200 Å as a substrate.

After the plasma processing of the junction surfaces, the piezoelectric substrate 300 and the protective substrates 306, 307 are superposed, which is sandwiched between the two metal jigs for junction so as to exert the force of 80Kg · f to 100Kg · f evenly to the entire quartz plate. Then it is heated in the vacuum furnace under 310°C for one hour. Thus, the junctions 308, 309, 310, 311 connect the piezoelectric substrate 300 and the protective substrates 306, 307 by the cold junction method or diffused junction. Actually, after a test sample is taken out of the vacuum furnace and is exposed in the natural condition, a physical destructive inspection is executed to the junction surface thereof, which confirmed a satisfactory diffused junction.

However, in case of the combination of a gold thin film and a silver thin film, although the plasma treatment is not executed to the junction surfaces, if the pressure is applied evenly to the piezoelectric substrate 300 and the protective substrates 306, 307 that are to be connected, it is confirmed that they can be connected only by the diffused junction processing, and there is not a problem in the connection layers.

Also in this embodiment, the junctions 308, 309, 310, 311 are defined to contain gold and silver. But, they may be made of more than one type of metals, diamonds, boron, or carbon nitride.

The metals mentioned above are, for example, platinum, gold, silver, copper, aluminum, nickel, chromium, molybdenum, tungsten, titanium, palladium, niobium, tantalum, beryllium, magnesium, tin, indium, and lead. The junction is formed either by one of these types of metals or by combining more than two types of them.

The boron is especially preferably the cubic boron (cBN). The carbon nitride is especially preferably the hexagonal carbon nitride (βC₃N₄).

An internal leader electrode 304 connects the electrode 302 and the junction 308 by either cold junction processing or the diffused junction. An internal leader electrode 305 connects the electrode 303 and the junction 311 by either cold junction processing or the diffused junction. The metal mentioned above is a metal with a relatively high conductivity, which is, for example, platinum, gold, silver, copper, and aluminum. One of these metals is used as the material for the internal leader electrode.

External connection electrodes 316, 317 are to connect the electrodes 302, 303 to the RF power supply, which is omitted in the drawing. The external connection electrodes 316, 317 are placed on one side of the protective substrate 307, on the opposite side thereof that faces the piezoelectric substrate 300. The gold electrode treatment is applied to the surfaces of the external connection electrodes 316, 317.

The external connection electrode 316 is electrically connected to the electrode 302 by way of the junction 308 and an external leader electrode 314. The external leader electrode 314 is placed on the sides of the piezoelectric substrate 300 and the protective substrate 307, and connects the junction 308 and the external connection electrode 316 by means of the cold junction processing or the diffused junction. The material used for the external leader electrode 314 is a metal with a relatively high conductivity. For example, platinum, gold, silver, copper, and aluminum. One of these metals is used as the material for the external leader electrode. Also, the gold electrode treatment is applied to the surface of the external leader electrode 314.

The external connection electrode 317 is electrically connected to the electrode 303 by way of the junction 311 and an external leader electrode 315. The external leader electrode 315 is placed on the side of the protective substrate 307, and connects the junction 311 and the external connection electrode 317 by means of the cold junction processing or the diffused junction. The material used for the external leader electrode 317 is a metal with a relatively high conductivity. For example, platinum, gold, silver, copper, and aluminum. One of these metals is used as the material for the external leader electrode. Also, the gold electrode treatment is applied to the surface of the external leader electrode 315.

By this construction, the piezoelectric resonator acquires the central frequency of 20.5MHz, and the equivalent resistance lower than 10 Ω. Also, there is no need to mention that the same effect can be acquired, even if the formation of the hermetic sealing part and that of the electrical connection part each are made independently.

According to the third embodiment, the piezoelectric substrate 300 can be sealed by the junctions 308, 309, 310, 311. Since the junctions 308, 309, 310, 311 are formed by means of the diffused junction or the cold junction, the electrical resistance thereof can be maintained low. Also, the junction parts have a greater strength than a fusible glass, so that they can be made extremely thin, and the piezoelectric substrate 300 and the protective substrates 306, 307 can be treated as if they were integrated into one unit. This means exactly the "package less".

Further, the external leader electrodes 314, 315, and the internal leader electrodes 304, 305 use the metals with a relatively high conductivity. Since the external connection electrodes and the electrodes are connected by the diffused junction processing or the cold junction processing, the electrical resistance thereof can be maintained low.

Furthermore, since the materials used for the piezoelectric substrate 300 and the protective substrates 306, 307 are the same, the hermetic sealing of the piezoelectric substrate 300 will not be broken by a thermal expansion.

Also, the recessed parts 312, 313 secure the oscillation area for the piezoelectric substrate 300.

As mentioned above, the piezoelectric resonator according to the invention has an advantage that the equivalent resistance can be lowered as a resonator, since the high Q-factor representing the capability of avoiding a dissipation of oscillation energy into the air can be realized by the junction carried out in a vacuum. The sealing in a vacuum effects an excellent result in the aging characteristic, and secures a stable electrode film on the piezoelectric plate.

The piezoelectric resonator according to the invention, having a configuration that makes unnecessary a ceramic package or a metal package to contain a piezoelectric element of the conventional piezoelectric resonator, does not require an extra mounting area, reduces a stray capacity from the package, which is a usual problem in the high frequency band, and effects a ultra thinness, micro miniaturization, and excellent high frequency characteristic in a form of chip components.

Since the adoption of the diffused junction technique or the cold junction technique in this invention maintains the stable connection of a low resistance at each junction for a long period, the increase of a resistance in the part bonded by the conductive adhesive can be avoided, which is a conventional problem, and the high reliability of various piezoelectric units can be accomplished, which is the biggest advantage of this invention.

By an appropriate material selection among lithium tantalate, lithium mobate, lithium tetraborate, aluminum phosphate, and piezoelectric ceramics, which are the piezoelectric materials having a high coupling coefficient as a piezoelectric substrate material, the piezoelectric resonator according to the invention realizes a piezoelectric unit having a low capacitance ratio which utilizes the thickness vibration. With regard to the manufacturing method, the existing technique already established can be applied, a mass production effect can be expected, and an excellent piezoelectric unit can be obtained. Further, the piezoelectric resonator according to the invention can be achieved also by applying the cold junction method to the piezoelectric polymer being a recent topic.

Thus, the piezoelectric resonator according to the invention is not limited to the resonator, and can be applied to the MCF filter. And in case that a three-layer-structured piezoelectric substrate is made of a single crystal, the selection of the same cut angle makes a matching with regard to the material constants, and reduces an influence of a strain caused by a heat in the manufacturing process and an influence of a residual stress during the process. And in case of the cold junction processing, these properties are still more improved, and the usability thereof is extremely enhanced.

Further, a quartz resonator using a quartz as a piezoelectric material will be mentioned as another example to which the invention is applied. For example, three sheets of quartz plates having a diameter ⌀ 5mm (thickness 80 µm, fundamental resonant frequency 20 MHz) are joined with the junction layers of metal films or diamond films or boron/carbon/nitrogen system films each having a thickness 1 µm, by means of the diffused junction processing or the cold junction, which is hermetically sealed. The physical thickness of the package-less piezoelectric unit according to the invention is 245 µm (including the thickness 3 µm of the external connection electrode). In contrast to this, the outside dimension in case of a conventional ceramic package containing a piezoelectric unit having a thickness 80 µm with the mesa processing applied is about ⌀ 7mm × 1.0 mm.

The piezoelectric resonator according to the invention requires a volume less than 1/5 in a mounting state in comparison to the conventional products, which gives a significant contribution to the reduction of the mounting area and the thinness of the total unit. Also, the piezoelectric resonator according to the invention displays an excellent effect in reducing a stray capacity from the package, which is a usual problem in using the package. By selecting a mesa structure (the thickness of the center: 16.7 µm) to a quartz disposed at the center of the three-layer-structure, a quartz resonator can be realized which operates at 100 MHz (the thickness of a diaphragm 16.7 µm), while the physical thickness of the laminated quartz resonator is maintained at 245 µm. Since less than ⌀ 1mm suffices for the area required for the oscillation of the diaphragm in a higher frequency band, a quartz resonator can be obtained which is immune to external shock and vibrations, etc., and excellent in resistance against environmental changes, while the outside shape of ⌀ 5mm is maintained.

### Industrial applicability

The invention relates to a structure of a piezoelectric plate itself of a package-less piezoelectric unit that utilizes the thickness vibration of the bulk wave by the piezoelectric plate, and especially intends that the structure is used for piezoelectric chip components in every possible frequency band; and it relates to a piezoelectric unit of an integrated structure with the same piezoelectric plates laminated in three layers, and provides a package-less piezoelectric resonator and a package-less monolithic crystal filter (MCF) that are compatible with ultra thinness, ultra micro-miniaturization, and higher frequency.

## Claims

1. A piezoelectric resonator comprising:
a piezoelectric substrate that generates a piezoelectric resonation;
electrodes mounted on a front side and a rear side of the piezoelectric substrate;
protective substrates of the same material as the piezoelectric substrate, disposed to be superposed on the front side and the rear side of the piezoelectric substrate; and
junctions that connect the piezoelectric substrate and the protective substrates by means of a diffused junction or a cold junction.

2. A piezoelectric resonator as claimed in Claim 1, wherein the junctions are made of either one of more than one type of metals, diamonds, boron, and carbon nitride.

3. A piezoelectric resonator as claimed in Claim 1, wherein the piezoelectric substrate is made of either one of a single crystal piezoelectric substrate, piezoelectric ceramics, and a piezoelectric polymer.

4. A piezoelectric resonator as claimed in Claim 1, further comprising:
external connection electrodes provided with the protective substrates; and
external leader electrodes made of a metal, which connect the junctions and the external connection electrodes by means of the diffused junction or the cold junction.

5. A piezoelectric resonator as claimed in Claim 1, further comprising internal leader electrodes made of a metal, which connect the electrodes and the junctions by means of the diffused junction or the cold junction.

6. A piezoelectric resonator as claimed in Claim 1, wherein a thickness of the junctions is greater than a thickness of the electrodes.

7. A piezoelectric resonator as claimed in Claim 1, wherein the piezoelectric substrate has recessed parts where the electrodes are mounted.

8. A piezoelectric resonator as claimed in Claim 1, wherein the protective substrates have recessed parts in correspondence with the electrodes.

9. A piezoelectric resonator as claimed in Claim 1, wherein the piezoelectric substrate and the protective substrates are made of single crystal plates of the same cut angle.

10. A piezoelectric resonator as claimed in Claim 1, wherein the piezoelectric substrate is made of a crystal, and the junctions contain gold and silver.
